# EUROPEAN PATENT APPLICATION

(11) **EP 4 848 132 A1**
(43) Date of publication of application: **02.12.2026**
(21) Application number: 25305763.2
(22) Date of filing: 27.05.2025
(51) Int. Cl.: G06F 30/12, G06F 30/17, G06T 19/20

(54) **GENERATING SKELETON REPRESENTATIONS OF 3D MODELS**

(71) Applicant: Dassault Systèmes, 78140 Vélizy-Villacoublay (FR)
(72) Inventor: VERGNES, Laurent, VELIZY VILLACOUBLAY (FR); GIRODENGO, Philippe, VELIZY VILLACOUBLAY (FR)
(74) Representative: Bandpay & Greuter

(57) **Abstract**

The disclosure notably relates to a computer-implemented method for designing a 3D model of an object. The method comprises obtaining (S10) the 3D model of the object. The 3D model is represented by a sequence of one or more typed operations. Each typed operation is defined by a set of respective parameters. The method comprises generating (S20) a skeleton representation of the 3D model comprising one or more shared manipulable elements, each referenced by at least two respective typed operations. A reference between a given shared manipulable element and a given typed operation defining a displacement relationship between the shared manipulable element and a parameter defining the given typed operation. Such a method improves solution for managing interactions and propagation of typed operations during mechanical part design.

## Description

### TECHNICAL FIELD

The disclosure relates to the field of computer programs and systems, and more specifically to a method, system and program for designing a 3D model of an object.

### BACKGROUND

A number of systems and programs are offered on the market for the design, the engineering and the manufacturing of objects. CAD is an acronym for Computer-Aided Design, e.g. it relates to software solutions for designing an object. CAE is an acronym for Computer-Aided Engineering, e.g. it relates to software solutions for simulating the physical behavior of a future product. CAM is an acronym for Computer-Aided Manufacturing, e.g. it relates to software solutions for defining manufacturing processes and operations. In such computer-aided design systems, the graphical user interface plays an important role as regards the efficiency of the technique. These techniques may be embedded within Product Lifecycle Management (PLM) systems. PLM refers to a business strategy that helps companies to share product data, apply common processes, and leverage corporate knowledge for the development of products from conception to the end of their life, across the concept of extended enterprise. The PLM solutions provided by Dassault Systèmes (under the trademarks CATIA, ENOVIA and DELMIA) provide an Engineering Hub, which organizes product engineering knowledge, a Manufacturing Hub, which manages manufacturing engineering knowledge, and an Enterprise Hub which enables enterprise integrations and connections into both the Engineering and Manufacturing Hubs. All together the system delivers an open object model linking products, processes, resources to enable dynamic, knowledge-based product creation and decision support that drives optimized product definition, manufacturing preparation, production and service.

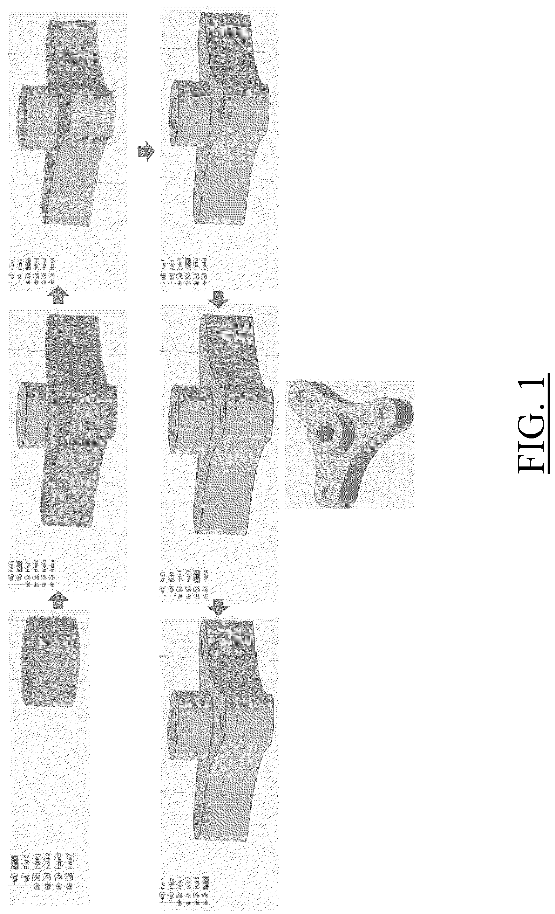

In current mechanical part design, a conventional feature-based methodology is employed, in which material is incrementally added or removed until the final shape of a part is achieved. In this process, each modification (hereinafter also referred to as a "typed operation") is sequentially applied to form a features tree that defines the designed part. FIG. 1 shows an example of different typed operations defined and executed to obtain an example part. This approach is integrated with CAD systems and plays a crucial role in the overall design workflow. Examples of typed operations include material addition operations, such as the Pad operation, the Shaft operation and the Draft operation. Examples also include material removal operations, such as the Pocket operation, the Groove operation, as well as operations such as Split, Fillet, Chamfer and Hole.

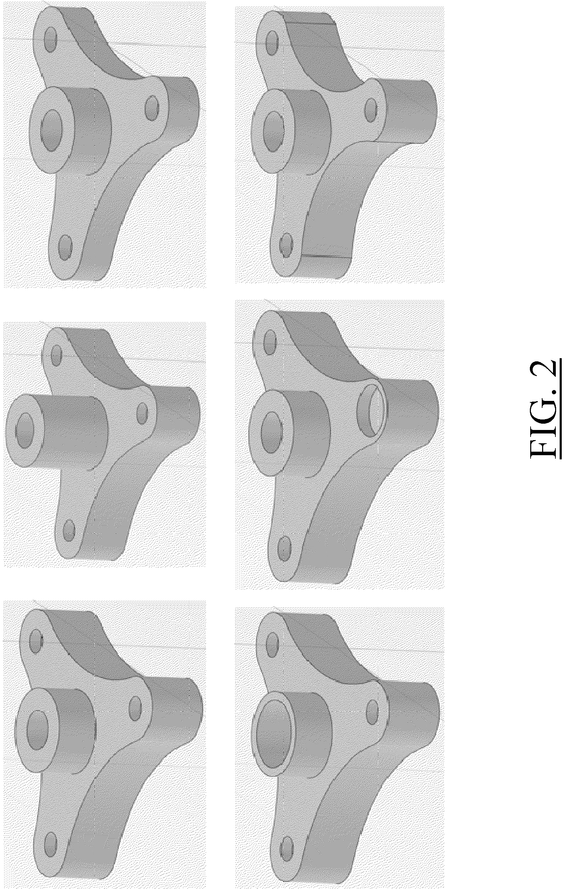

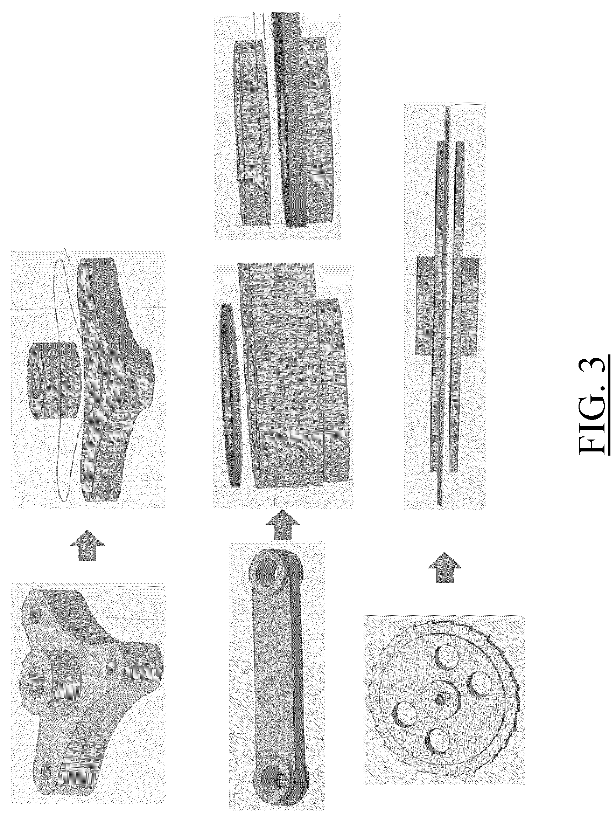

Although the feature-based methodology facilitates the generation of design variants, as illustrated in FIG. 2, which shows six variants of a part obtained by varying the parameters of the typed operations used in its creation, the successful update of a model following parameter modifications is highly dependent on the correct construction and interaction of the typed operations, which relies on the designer's expertise. In particular, inexperienced designers may encounter unexpected outcomes, such as compromised material continuity, failure to propagate modifications to neighboring operations, or even complete model update errors. For example, FIG. 3 shows three instances of disconnections (unrealistic and undesirable) observed between portions of the same part when, for example, the thickness of one sub-component of the part is varied. In such cases, the user must then manually rework the model to resolve these issues, which forces a redesign of the part. This process is particularly difficult and tedious and underscores the ergonomic shortcomings of the current solutions.

Within this context, there is still a need for an improved solution for managing interactions and propagation of typed operations during mechanical part design.

### SUMMARY

It is therefore provided a computer implemented method for designing a 3D model of an object. The method comprises obtaining the 3D model of the object. The 3D model is represented by a sequence of one or more typed operations. Each typed operation is defined by a set of respective parameters. The method comprises generating a skeleton representation of the 3D model comprising one or more shared manipulable elements, each referenced by at least two respective typed operations. A reference between a given shared manipulable element and a given typed operation defining a displacement relationship between the shared manipulable element and a parameter defining the given typed operation.

The method may comprise one or more of the following:
- The generating of the skeleton representation comprises determining the one or more shared manipulable elements of the skeleton representation by:
   ∘ extracting candidate parameters of the one or more typed operations representing the 3D model; and
   ∘ sequentially processing the extracted candidate parameters to add to the skeleton representation a shared manipulable element for each set of at least two similar extracted candidate parameters;
- The sequentially processing comprises, for each extracted candidate parameter:
   ∘ determining whether the candidate parameter corresponds to an already added shared manipulable element in the skeleton representation; and
   ∘ if no corresponding shared manipulable element exists, adding the candidate parameter as a new shared manipulable element in the skeleton representation; or
   ∘ if a corresponding shared manipulable element exists, establishing a reference between the typed operation associated with the candidate parameter and the existing shared manipulable element;
- The determining of whether the candidate parameter corresponds to an already added shared manipulable element in the skeleton representation is performed by comparing a geometry of the candidate parameter and a geometry of each shared manipulable element already present in the skeleton;
- The comparison is performed by considering a predetermined tolerance;
- The extracted candidate parameters comprise all parameters of the one or more typed operations that belong to a predetermined set of categories;
- The predetermined set of categories includes:
   ∘ a plan category,
   o a point category, and
   ∘ an axis category;
- The obtaining of the 3D model comprises determining the one or more typed operations of the 3D model by reconstructing an initial model;
- The initial model is:
   ∘ a mesh of the object,
   ∘ a tessellation of the object, or
   ∘ a Brep;
- The obtaining of the 3D model comprises determining the one or more typed operations of the 3D model from an existing model designed by a user;
- The one or more typed operations include:
   ∘ at least one extrusion operation,
   ∘ at least one revolution operation, and/or
   ∘ at least one hole operation; and/or
- The method further comprises modifying the 3D model through user interaction with at least one shared manipulable element of the skeleton representation.

It is further provided a computer program comprising instructions which, when executed by a computer, cause the computer to carry out the method.

It is further provided a computer readable storage medium having recorded thereon the computer program.

It is further provided a system comprising a processor coupled to a memory, the memory having recorded thereon the computer program. The processor may further be coupled to a graphical user interface.

It is further provided a device comprising a data storage medium having recorded thereon the computer program.

The device may form or serve as a non-transitory computer-readable medium, for example on a SaaS (Software as a service) or other server, or a cloud based platform, or the like. The device may alternatively comprise a processor coupled to the data storage medium. The device may thus form a computer system in whole or in part (e.g. the device is a subsystem of the overall system). The system may further comprise a graphical user interface coupled to the processor.

### BRIEF DESCRIPTION OF THE DRAWINGS

Non-limiting examples will now be described in reference to the accompanying drawings, where:
- FIGs. 1 to 3 illustrate design variants of a 3D model;
- FIG. 4 shows a flowchart of an example of the method;
- FIG. 5 illustrates one problem of existing solutions;
- FIG. 6 illustrates the obtaining of the 3D model;
- FIGs. 7 to 16 illustrate the generating of the skeleton generation;
- FIGs. 17 to 23 illustrate a detailed example of executing of the method;
- FIG. 24 shows an example of a graphical user interface of the system; and
- FIG. 25 shows an example of the system.

### DETAILED DESCRIPTION

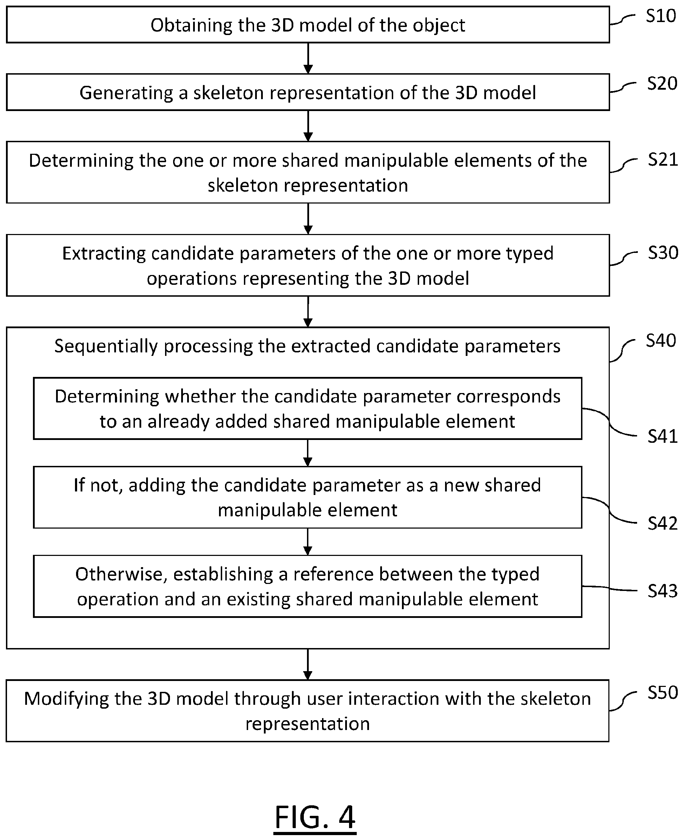

With reference to the flowchart of FIG. 4, it is proposed a computer-implemented method for designing a 3D model of an object. The method comprises obtaining S10 the 3D model of the object. The 3D model is represented by a sequence of one or more typed operations. Each typed operation is defined by a set of respective parameters. The method comprises generating S20 a skeleton representation of the 3D model comprising one or more shared manipulable elements, each referenced by at least two respective typed operations. A reference between a given shared manipulable element and a given typed operation defining a displacement relationship between the shared manipulable element and a parameter defining the given typed operation.

Such a method improves solution for managing interactions and propagation of typed operations during mechanical part design.

Notably, the method streamlines the design process by capturing the entire design history as a sequence of parameterized typed operations. By creating a skeleton representation of the 3D model, the approach enables changes made to one element to be automatically and coherently propagated across all related operations. This significantly reduces the need for extensive manual rework, thereby diminishing the risk of errors when modifications are introduced.

Moreover, the establishment of shared manipulable elements enhances consistency throughout the design. These elements serve as common references between multiple typed operations, ensuring that adjustments to a single parameter are synchronized across every affected operation. This integrated network of displacement relationships helps maintain the inherent design intent and geometric integrity across complex models.

Furthermore, the method offers important ergonomic benefits for users. By automating the propagation of modifications, it alleviates the often burdensome and error-prone task of manually reconfiguring operations following a parameter change. This intuitive workflow not only improves productivity but also enhances the overall user experience, making the design process more accessible and less cumbersome for both experienced and inexperienced designers.

Additionally, because the method improves the design of the modeled object through its systematic use of typed operations, skeleton representation and shared manipulable elements, the manufacturing process also benefits. The objects produced using this method inherit the robust geometrical properties and precise propagation of modifications, ultimately leading to objects that exhibit enhanced dimensional accuracy and durability. As a result, the manufacturing process is optimized and productivity is increased, thereby also improving the final products.

The method is computer-implemented. This means that steps (or substantially all the steps) of the method are executed by at least one computer, or any system alike. Thus, steps of the method are performed by the computer, possibly fully automatically, or, semi-automatically. In examples, the triggering of at least some of the steps of the method may be performed through user-computer interaction. The level of user-computer interaction required may depend on the level of automatism foreseen and put in balance with the need to implement user's wishes. In examples, this level may be user-defined and/or pre-defined.

For example, the step S50 of modifying the 3D model using at least one shared manipulable element may be performed through user interactions. In examples, the one or more shared manipulable elements may be manipulated by using the skeleton representation. The method may comprise displaying the generated skeleton representation to the user. Then, the modifying step S50 may involve the user interacting with one of the shared manipulable elements in the displayed skeleton representation, wherein the element is selected and subsequently modified through interactive actions such as dragging, sliding, or entering new values. Following this user interaction, the modifying step S50 may further comprise automatically updating the corresponding parameters in all typed operations that reference the modified shared element, thereby ensuring that any change is seamlessly and uniformly applied throughout the entire model.

In examples, the one or more shared manipulable elements may alternatively be manipulated by using the parameters from which they originate. For example, if the shared manipulable element originates from a common plane used in several typed operations, the modifying step S50 may comprise adjusting that plane by the user. In this scenario, the user may modify the plane by dragging or sliding its graphical representation as displayed on the screen. The action of modifying the plane may then automatically trigger the modifying step S50 to update the relevant geometric parameters across all typed operations that reference that same plane.

If the selected element corresponds to a point, the modifying step S50 may comprise the user repositioning that point by dragging it across the interface or by entering new coordinate values. In the case where the shared manipulable element pertains to an axis, the modifying step S50 may comprise the user altering the axis through rotation or linear translation provided by the interface controls. Such modifications result in the automatic recalculation and updating of the associated parameters in all typed operations that reference the modified axis.

A typical example of computer-implementation of a method is to perform the method with a system adapted for this purpose. The system may comprise a processor coupled to a memory and a graphical user interface (GUI), the memory having recorded thereon a computer program comprising instructions for performing the method. The memory may also store a database. The memory is any hardware adapted for such storage, possibly comprising several physical distinct parts (e.g. one for the program, and possibly one for the database).

By "database", it is meant any collection of data (i.e. information) organized for search and retrieval (e.g. a relational database, e.g. based on a predetermined structured language, e.g. SQL). When stored on a memory, the database allows a rapid search and retrieval by a computer. Databases are indeed structured to facilitate storage, retrieval, modification, and deletion of data in conjunction with various data-processing operations. The database may consist of a file or set of files that can be broken down into records, each of which consists of one or more fields. Fields are the basic units of data storage. Users may retrieve data primarily through queries. Using keywords and sorting commands, users can rapidly search, rearrange, group, and select the field in many records to retrieve or create reports on particular aggregates of data according to the rules of the database management system being used.

The method generally manipulates modeled objects. A modeled object is any object defined by data stored e.g. in the database. By extension, the expression "modeled object" designates the data itself. According to the type of the system, the modeled objects may be defined by different kinds of data. The system may indeed be any combination of a CAD system, a CAE system, a CAM system, a PDM system and/or a PLM system. In those different systems, modeled objects are defined by corresponding data. One may accordingly speak of CAD object, PLM object, PDM object, CAE object, CAM object, CAD data, PLM data, PDM data, CAM data, CAE data. However, these systems are not exclusive one of the other, as a modeled object may be defined by data corresponding to any combination of these systems. A system may thus well be both a CAD and PLM system, as will be apparent from the definitions of such systems provided below.

By CAD system, it is additionally meant any system adapted at least for designing a modeled object on the basis of a graphical representation of the modeled object, such as CATIA. In this case, the data defining a modeled object comprise data allowing the representation of the modeled object. A CAD system may for example provide a representation of CAD modeled objects using edges or lines, in certain cases with faces or surfaces. Lines, edges, or surfaces may be represented in various manners, e.g. non-uniform rational B-splines (NURBS). Specifically, a CAD file contains specifications, from which geometry may be generated, which in turn allows for a representation to be generated. Specifications of a modeled object may be stored in a single CAD file or multiple ones. The typical size of a file representing a modeled object in a CAD system is in the range of one Megabyte per part. And a modeled object may typically be an assembly of thousands of parts.

In the context of CAD, a modeled object may typically be a 3D modeled object, e.g. representing a product such as a part or an assembly of parts, or possibly an assembly of products. By "3D modeled object", it is meant any object which is modeled by data allowing its 3D representation. A 3D representation allows the viewing of the part from all angles. For example, a 3D modeled object, when 3D represented, may be handled and turned around any of its axes, or around any axis in the screen on which the representation is displayed. This notably excludes 2D icons, which are not 3D modeled. The display of a 3D representation facilitates design (i.e. increases the speed at which designers statistically accomplish their task). This speeds up the manufacturing process in the industry, as the design of the products is part of the manufacturing process.

The 3D modeled object may represent the geometry of a product to be manufactured in the real world subsequent to the completion of its virtual design with for instance a CAD software solution or CAD system, such as a (e.g. mechanical) part or assembly of parts (or equivalently an assembly of parts, as the assembly of parts may be seen as a part itself from the point of view of the method, or the method may be applied independently to each part of the assembly), or more generally any rigid body assembly (e.g. a mobile mechanism). A CAD software solution allows the design of products in various and unlimited industrial fields, including: aerospace, architecture, construction, consumer goods, high-tech devices, industrial equipment, transportation, marine, and/or offshore oil/gas production or transportation. The 3D modeled object designed by the method may thus represent an industrial product which may be any mechanical part, such as a part of a terrestrial vehicle (including e.g. car and light truck equipment, racing cars, motorcycles, truck and motor equipment, trucks and buses, trains), a part of an aerial vehicle (including e.g. airframe equipment, aerospace equipment, propulsion equipment, defense products, airline equipment, space equipment), a part of a naval vehicle (including e.g. navy equipment, commercial ships, offshore equipment, yachts and workboats, marine equipment), a general mechanical part (including e.g. industrial manufacturing machinery, heavy mobile machinery or equipment, installed equipment, industrial equipment product, fabricated metal product, tire manufacturing product), an electro-mechanical or electronic part (including e.g. consumer electronics, security and/or control and/or instrumentation products, computing and communication equipment, semiconductors, medical devices and equipment), a consumer good (including e.g. furniture, home and garden products, leisure goods, fashion products, hard goods retailers' products, soft goods retailers' products), a packaging (including e.g. food and beverage and tobacco, beauty and personal care, household product packaging).

A CAD system may be history-based. In this case, a modeled object is further defined by data comprising a history of geometrical features. A modeled object may indeed be designed by a physical person (i.e. the designer/user) using standard modeling features (e.g. extrude, revolute, cut, and/or round) and/or standard surfacing features (e.g. sweep, blend, loft, fill, deform, and/or smoothing). Many CAD systems supporting such modeling functions are history-based system. This means that the creation history of design features is typically saved through an acyclic data flow linking the said geometrical features together through input and output links. The history based modeling paradigm is well known since the beginning of the 80's. A modeled object is described by two persistent data representations: history and B-rep (i.e. boundary representation). The B-rep is the result of the computations defined in the history. The shape of the part displayed on the screen of the computer when the modeled object is represented is (e.g. a tessellation of) the B-rep. The history of the part is the design intent. Basically, the history gathers the information on the operations which the modeled object has undergone. The B-rep may be saved together with the history, to make it easier to display complex parts. The history may be saved together with the B-rep in order to allow design changes of the part according to the design intent.

By PLM system, it is additionally meant any system adapted for the management of a modeled object representing a physical manufactured product (or product to be manufactured). In a PLM system, a modeled object is thus defined by data suitable for the manufacturing of a physical object. These may typically be dimension values and/or tolerance values. For a correct manufacturing of an object, it is indeed better to have such values.

By CAM solution, it is additionally meant any solution, software of hardware, adapted for managing the manufacturing data of a product. The manufacturing data generally includes data related to the product to manufacture, the manufacturing process and the required resources. A CAM solution is used to plan and optimize the whole manufacturing process of a product. For instance, it can provide the CAM users with information on the feasibility, the duration of a manufacturing process or the number of resources, such as specific robots, that may be used at a specific step of the manufacturing process; and thus allowing decision on management or required investment. CAM is a subsequent process after a CAD process and potential CAE process. Such CAM solutions are provided by Dassault Systèmes under the trademark DELMIA^{®}.

By CAE solution, it is additionally meant any solution, software of hardware, adapted for the analysis of the physical behavior of a modeled object. A well-known and widely used CAE technique is the Finite Element Method (FEM) which typically involves a division of a modeled objet into elements which physical behaviors can be computed and simulated through equations. Such CAE solutions are provided by Dassault Systèmes under the trademark SIMULIA^{®}. Another growing CAE technique involves the modeling and analysis of complex systems composed a plurality components from different fields of physics without CAD geometry data. CAE solutions allow the simulation and thus the optimization, the improvement and the validation of products to manufacture. Such CAE solutions are provided by Dassault Systèmes under the trademark DYMOLA^{®}.

PDM stands for Product Data Management. By PDM solution, it is meant any solution, software of hardware, adapted for managing all types of data related to a particular product. A PDM solution may be used by all actors involved in the lifecycle of a product: primarily engineers but also including project managers, finance people, sales people and buyers. A PDM solution is generally based on a product-oriented database. It allows the actors to share consistent data on their products and therefore prevents actors from using divergent data. Such PDM solutions are provided by Dassault Systèmes under the trademark ENOVIA^{®}.

"Designing a 3D modeled object" (or "3D model") designates any action or series of actions which is at least part of a process of elaborating a 3D modeled object. Thus, the method may comprise creating the 3D modeled object from scratch. Alternatively, the method may comprise providing a 3D modeled object previously created, and then modifying the 3D modeled object. In this context, the 3D modeled object may represent a specific part or component, and modifications may comprise reinforcing the part following a rupture during use, adapting it to a new context of use, reducing its weight, or using it as a basis to create a new part by starting from an existing design rather than modeling it entirely from scratch. Such modifications may be performed by manipulating one or more shared manipulable elements of the skeleton representation generated for the 3D modeled object.

The method may comprise using the 3D model for manufacturing the object (or product) that the 3D model represents. In case the method includes the modifying step S50, the manufacturing process may comprise using the modified 3D model for manufacturing the object (or product) that the modified 3D object represents. For example, the method may be included in a manufacturing process, which may comprise, after performing the method, producing a physical product corresponding to the modeled object. In any case, the modeled object designed by the method may represent a manufacturing object. The modeled object may thus be a modeled solid (i.e. a modeled object that represents a solid). The manufacturing object may be a product, such as a part, or an assembly of parts. Because the method improves the design of the modeled object, the method also improves the manufacturing of a product and thus increases productivity of the manufacturing process.

The first step of obtaining S10 the model is now discussed.

The obtaining (S10) of the 3D model may be carried out according to two alternative approaches. In one approach, the method may reconstruct an initial model from raw geometric data; in another approach, the method may extract one or more typed operations from an existing user-designed model. Each alternative may comprise a series of sub-steps that allow obtaining the sequence of typed operation(s) representing the 3D model.

In the first approach, the method may begin by acquiring an initial model that may be obtained from various sources. For example, the initial model may be a mesh of the object (e.g., obtained from a scan), a tessellation of the object (e.g., derived from imaging or sensor data), or a Brep representing a "dead" solid (or the result of executing a specification). For example, the method may comprise scanning an external surface of the object (e.g., using a scanner) to obtain a point cloud of the object and fitting a mesh on the obtained point cloud, thereby obtaining a representation of the external surface of said object.

Once this initial model has been obtained, the method may comprise a geometrically analyzing step for segmenting and identifying the model's volumetric features. This analyzing step may comprise analyzing the structure of the initial model to identify discrete modifications corresponding to individual typed operations. Subsequently, the method may determine one or more typed operations by extracting characteristic features (such as profiles, edges, or surfaces) from the initial model. Each extracted operation, which may define the addition or removal of material from the object, is then completely characterized by a set of corresponding parameters (e.g., directions, angles, distances, axes) to form the sequence of one or more typed operations of the model. The method thereby generates a feature tree from the initial model (i.e., generates the sequence of typed operations that allows obtaining this initial model). This generation may, for example, be performed as described in the European Patent Applications EP24305527.4, EP22305935.3 (published as EP4300344A1), EP22305934.6 (published as EP4300343A1) and/or EP18306889.9 (published as EP3675059B1) (e.g., when the initial model is a mesh), all of which are incorporated herein by reference.

In the second approach, the obtaining S10 of the 3D model may be performed directly by analyzing an existing user-designed model. In such embodiments, the method may retrieve the sequence of typed operations from the design history stored in the CAD system, or alternatively, may recompute these operations by analyzing the current state of the user-designed model. This alternative may bypass the need for reconstructing an initial model from raw data since the operations and their associated parameters have already been defined. In either case, the extracted sequence of typed operations may then serve as the basis for generating the skeleton representation of the 3D model.

A typed operation may be understood as an operation that is completely and solely defined by a corresponding set of typed parameters. In other words, it may be modeled as a function that takes, as input, the set of typed parameters and instantiates an output according to the type of the operation and the values of those parameters. The result of the instantiation of a typed operation on a 3D modeled object is certain and well-defined, provided that all required parameters are set. However, for the same set of typed parameters, the output may vary depending on the specific typed operation being instantiated. That is, different typed operations applied to identical parameters may produce different results. For example, a typed operation corresponding to the creation of a sphere may be entirely defined by a center location and a radius. These two parameters, both typed, are sufficient to instantiate the sphere, since the topology of the sphere is uniquely determined by them. More generally, the set of typed parameters required by a given typed operation is predefined, and each parameter is associated with a known type. All parameter types are known before instantiation time, that is, before the moment the operation is actually executed, computed, and the 3D object is stored in memory.

Each typed operation may represent a discrete computer-executable modification that is fully defined by a corresponding set of parameters. In general, a typed operation may specify a transformation of an object either by adding or removing material. The associated set of parameters may include, for example, geometric profiles, directions, distances, angles, axes, tolerances, and edges required to achieve the intended modification.

In examples, the one or more typed operations may include at least one extrusion operation. An extrusion operation may either add or remove material by extending a profile along a given direction and for a given distance. For example, the one or more typed operations may include one or more Pad operations, which are extrusion operations used to add material by extruding a profile. Each Pad operation may be defined by parameters including the profile to be extruded, the direction of extrusion, and the extrusion distance. Alternatively or additionally, the one or more typed operations may include one or more Pocket operations, which are also extrusion operations but used to remove material. Each Pocket operation may similarly be defined by the profile to be extruded, the direction of extrusion, and the distance over which material is removed.

In examples, the one or more typed operations may include at least one revolution operation. A revolution operation may transform the model by revolving a profile around a defined axis through a specified angle. For example, the one or more typed operations may include one or more Shaft operations, which are revolution operations used to add material. Each Shaft operation may be defined by parameters such as the profile to be revolved, the axis of revolution, and the rotation angle. Alternatively or additionally, the one or more typed operations may include one or more Groove operations, which are revolution operations used to remove material by revolving a profile around an axis. A Groove operation may also be defined by parameters including the profile, the axis, and the angle.

In examples, the one or more typed operations may include at least one hole operation. A hole operation may create a void in the model and may be defined by parameters such as an axis, a diameter, and a depth.

The one or more typed operations may further include additional types of operations. For example, the one or more typed operations may include one or more Draft operations, wherein each Draft operation may apply a taper on selected faces by imposing a predetermined angle relative to a reference direction. The Draft operation may be defined by parameters including the draft angle, the reference direction, and the set of faces. Alternatively of additionally, the one or more typed operations may include one or more Split operations, wherein each Split operation may divide a solid by a surface and retain only one side of the resulting geometry. The Split operation may be defined by parameters including the dividing surface. Alternatively or additionally, the one or more typed operations may include one or more Fillet operations, wherein each Fillet operation may round an edge with a specified radius, defined by the edge and the radius value. Alternatively or additionally, the one or more typed operations may include one or more Chamfer operations, each defined by an edge and an angle, to apply a bevel.

The second step of generating S20 the skeleton representation is now discussed.

A skeleton representation may be understood as an abstract model of the 3D object that reduces its complexity by capturing (e.g., only) the dependencies between the parameters of the model's typed operation(s). The skeleton representation may comprise nodes corresponding to the shared manipulable element(s) and references linking these nodes to the parameters of the typed operations.

A shared manipulable element may be defined as a control node within the skeleton representation that may be directly manipulated to effect modifications in the 3D model. Each shared manipulable element may be referenced by at least two respective typed operations. The term "referenced" indicates that the method records a connection between the shared manipulable element and each parameter of a typed operation referencing this shared manipulable element. For example, each parameter referencing a shared manipulable element may comprise an address of this shared manipulable element. In this way, during the instantiation of the considered typed operation, the instantiation may consider that the parameter value is the one located at the address, i.e., the value recorded at the location of the shared manipulable element. In example, the generated skeleton representation may comprise, alternatively or additionally, one or more shared manipulable elements each referenced by only one respective typed operation. Thus, in examples, the generated skeleton representation may comprise one or more shared manipulable elements, each referenced by at least one respective typed operation.

To move a shared manipulable element, the user may move one of the parameters referenced by the element, thereby automatically modifying the shared manipulable element and each parameter referenced by the same shared manipulable element (e.g., by moving the referenced plane, point, or axis). Alternatively or additionally, the value of the element may be modified directly by the user. For example, the skeleton representation may be displayed separately on the screen, adjacent to the model. The user may thus directly modify the values of shared manipulable elements by interacting with the displayed skeleton representation (e.g., by inputting different values to the shared manipulable elements or performing slide or drag operations on them).

The reference from a shared manipulable element to a parameter of a typed operation defines a displacement relationship. This displacement relationship means that when the shared manipulable element is moved (i.e., its value is changed), the associated parameter is automatically adjusted (i.e., its value is automatically changed accordingly), causing a corresponding change in the typed operation having the said parameter. For example, if a node is translated, rotated, or scaled within the skeleton representation, the displacement relationship ensures that the relevant typed operations update their parameters consistently, thereby propagating the change throughout the 3D model.

The generation S20 of the skeleton representation may be performed in any manner. The generation S20 of the skeleton representation may comprise the determining S21 of all its shared manipulable elements (e.g. successively). To this end, the generation S20 may initially include an extraction step S30 that retrieves all candidate parameters of the model, i.e. from among all parameters of each typed operation of the model. These candidate parameters are those potentially usable to serve as references in a shared manipulable element (that is to say, it is possible that another typed operation may possess an identical parameter). In examples, the candidate parameters may be determined such that the extracted candidate parameters comprise all parameters of the one or more typed operations that belong to a predetermined set of categories (e.g., planes or points). For example, the method may comprise taking all available parameters and then retaining only those that belong to this predefined list of categories. For example, the predetermined set of categories may include a plan category, a point category and an axis category. In that case, the candidate parameters may include each plan, point and axis of the model (i.e., that are used in one of the typed operations).

In examples, the generating step S20 may further comprise processing (e.g., sequentially) the extracted candidate parameters to add to the skeleton representation a shared manipulable element for each set of at least two similar candidate parameters. In other words, the method proceeds by examining the candidate parameters one after the other. When two or more candidate parameters with similar characteristics are identified, a shared manipulable element is added to the skeleton representation. This means that multiple typed operations referencing parameters with similar geometric or functional properties may be associated with the same shared manipulable element.

In examples, the method may process the extracted candidate parameters sequentially (step S40) and, for each candidate parameter, determine (step S41) whether it corresponds to an already added shared manipulable element in the skeleton representation. If no corresponding shared manipulable element exists, the method may comprise adding (step S42) the candidate parameter as a new shared manipulable element. In that case, the method may comprise establishing a reference between the typed operation associated with the candidate parameter and the newly shared manipulable element (the step of adding S42 the candidate parameter as a new shared manipulable element may comprise establishing such a reference between the typed operation associated with the candidate parameter and the newly shared manipulable element). Alternatively, if a candidate parameter is found to correspond to a shared manipulable element that has already been added, a reference may be established between the typed operation associated with the candidate parameter and this existing shared element (step S43). This approach is particularly advantageous as it improves computational efficiency and accuracy in correlating candidate parameters with corresponding elements, thereby enhancing the consistency and robustness of the skeleton representation. At the end, the method may optionally remove each shared manipulable element that is referenced by a single parameter, thereby retaining only those that are referenced by at least two parameters.

In examples, the determination of whether a candidate parameter corresponds to an already added shared manipulable element (step S41) may be executed by comparing the geometry of the candidate parameter with that of each shared manipulable element present in the skeleton representation. It is to be understood that the geometry of a shared manipulable element is derived from the parameter from which it initially originates (i.e., from an execution of step S42). During this comparison, the method may comprise comparing geometric attributes (such as dimensions, orientations, location, or any other relevant feature) of the candidate parameter with those of each shared manipulable element already added to the skeleton representation.

The comparison, using the aforementioned geometric attributes, between the geometry of the candidate parameter and that of each shared manipulable element, may be performed in any suitable manner. The aim of the comparison is to determine whether the geometry of the candidate parameter is (e.g., substantially) equal to that of a previously added shared manipulable element (i.e., to that of a candidate parameter that has already been processed). The comparison may involve the shape and/or location of the parameter. For example, planes passing through the same point and having equivalent normal vectors may be considered similar. In a similar manner, two points may be considered similar if they are coincident (or within a specified distance of one another). Furthermore, two axes may be regarded as similar if they are collinear and aligned (e.g., within a predetermined angular tolerance).

In examples, the comparison (i.e., equality in terms of geometry) may be carried out while additionally considering a predetermined tolerance. This approach is particularly advantageous as it enhances computational efficiency and accuracy in identifying corresponding shared manipulable elements, thereby contributing to a more robust and reliable skeleton representation. The geometry of the candidate parameter in question may refer to the axis, the surface, or a specific point, depending on the nature of the candidate parameter. For example, if the candidate parameter represents an axis, the method may examine all axes extracted from various typed operations to determine whether an identical axis (used by another typed operation) already exists within the predetermined tolerance. In examples, this tolerance may be a function of the model. For example, it may be substantially close to the manufacturing tolerance of the object considered. The predetermined tolerance may for example be set to a value less than half of the manufacturing tolerance.

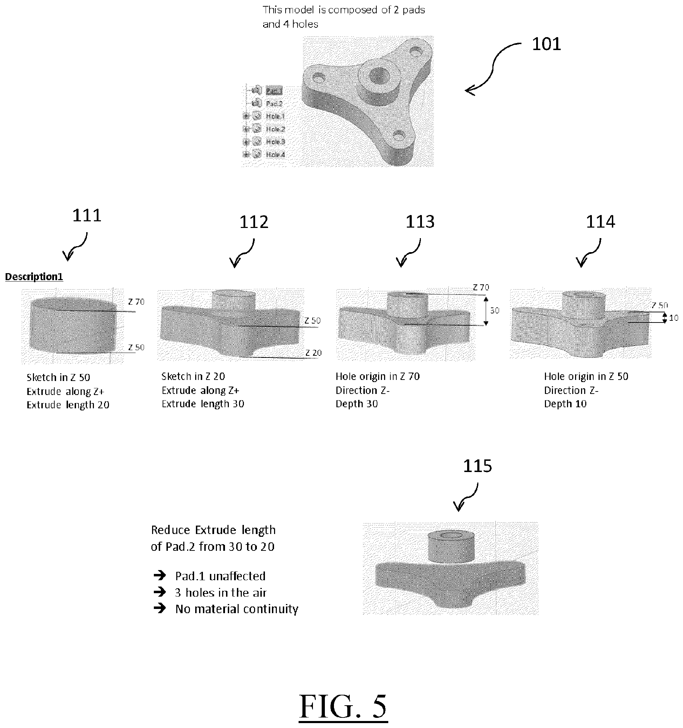

With reference to FIGs. 5 to 25, examples of implementations of the method are now presented.

The method significantly simplifies the editing of existing models and improves their robustness. In conventional modeling, the ability to maintain a valid model after modifying a parameter depends strongly on how the typed operations are constructed and how they interact with each other. This robustness often relies on the designer's skill: an expert designer typically creates a robust feature tree that allows flexible modifications, whereas a beginner may encounter unexpected issues after even a minor change. For a given shape, different sequences of typed operations can lead to several non-equivalent descriptions, which in turn affect the model's behavior when edited.

An example illustrating this situation is shown in FIG. 5. In this example, the model is composed of a sequence of six typed operations. The numerical values mentioned below are expressed in the model's unit system (e.g., centimeters). The first typed operation 111 consists of extruding a circle along the Z+ direction from a first plane (located at Z=50) with a length of 20 to create an upper portion, referred to as the first pad (Pad.1). The second typed operation 112 extrudes a sketch along the Z+ direction from a second plane (located at Z=20) with a length of 30 to form a lower portion, referred to as the second pad (Pad.2). The third typed operation 113 consists of a hole operation originating from a third plane (located at Z=70) and extending along the Z- direction with a depth of 30 to drill a central opening (Hole.1). Several fourth typed operations 114 further drill the three extremities of the lower portion, starting from the same third plane (Z=50) along the Z- direction, each with a depth of 10 (Hole.2, Hole.3 and Hole.4).

In this configuration, a problem arises when the user changes the extrusion length of the second pad from 30 to 20. In that case, the first pad remains unaffected (as shown in the resulting model 115). However, the three holes created by operation 113, which were initially properly connected to the solid material, are now entirely located in empty space. As a result, there is no longer any material continuity, and the intended structural connection through the holes is lost. If the part were manufactured in this state, it could lead to several issues, such as weak structural integrity, difficulties during the manufacturing process (e.g., unsupported drilling operations), and the risk of producing a defective part that does not meet functional requirements.

To address such issues, the method automatically identifies the wireframe geometrical elements (the typed operation parameters) that predominantly determine the shape of the model, creates these elements (as shared manipulable elements), and generates a skeleton representation that guides the editing process while enhancing robustness. The shared manipulable elements of this representation serve as levers on which the user can act to modify the model and define variants. Consequently, the productivity of designers is improved as the approach offers a robust solution for beginners and complements the existing designs of experts. Even though an expert designer may be able to manually resolve editing issues, such a process remains tedious and prone to human error. In contrast, the automated method not only streamlines the process but also reduces the risk of errors and ensures greater standardization across models. In both cases, the method facilitates the maintenance and evolution of the model throughout its life cycle.

The terminology used in this document is defined as follows:
- The **Brep model** comprises a solid model defined by its boundary representation, which is constituted by a set of connected surfaces.
- The **structure** (also named topology) comprises the method by which the geometrical elements are assembled in the Brep model. In the structure, an envelope comprises a set of faces, a face comprises a geometrical surface trimmed by one or several boundary wires, a wire comprises a set of edges, an edge comprises a geometrical curve trimmed by two vertices, and a vertex comprises a geometrical point.

- The **specifications** (also named sequence of specifications) comprise an ordered sequence of typed operations (involving addition or removal of material) that result in the final shape of the model. The modification of a given operation affects the final shape and provides a means to produce a variant of the model.
- The **feature** comprises a persistent object with a given type corresponding to a single operation. It is composed of input parameters and produces an output. For example, an extrude-type feature accepts a circle, a direction perpendicular to the circle plane, and a length to produce a solid cylinder. A feature is the solid that results from the executing of a typed operation.
- The **skeleton representation** is a data structure that comprises the shared manipulable elements generated by the method.

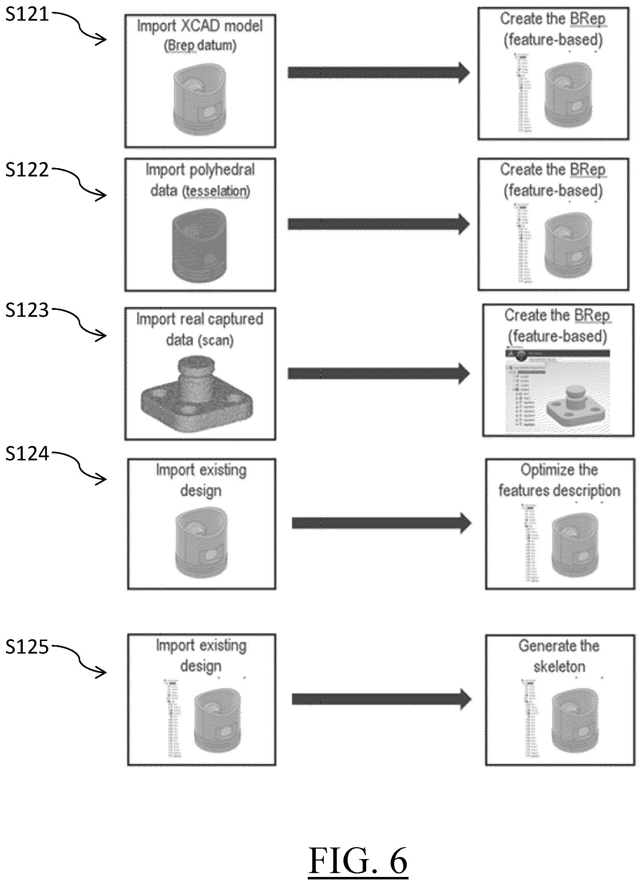

In a first step, the method comprises obtaining S10 the 3D model. Four distinguishing scenarios for this step are illustrated in FIG. 6.

In a first scenario, the method comprises obtaining an initial model that is a Brep model of the object and generating (S121, S122) the typed operation(s) of the 3D model by reconstructing the Brep model. In this first scenario, the input comprises a Brep model without specifications and, consequently, without editing capability. In an alternative example, the model taken as input may be a tessellated Brep model, which comprises a mesh computed on each face of the Brep model and representing it with fidelity and controlled accuracy. In that alternative case, the method comprises generating the typed operation(s) of the 3D model by reconstructing this tessellation model of the object. The context in this scenario typically may involve a Brep or tessellation model obtained from an import from another modeling system, sharing between a requestor and a supplier, or retrieval from a web model library when a user starts from an existing design and wishes to adapt it. The output is a model that includes its specification sequence, meaning the typed operation(s), with a skeleton representation generated by the method that complements the specifications and facilitates both editing and variant creation.

In a second scenario, the method comprises generating the specifications of an object starting from a capture of the real part. The method comprises obtaining an initial model that is a mesh representation of the object, the mesh being either provided directly or obtained by capturing the geometry of the physical object, for example using a laser scanner or by computing the mesh from a set of photographs. The method further comprises generating the sequence of typed operations S123 by reconstructing a structured model from the mesh. The input model comprises a mesh that lacks specifications and structural information, and therefore has no editing capability.

This second scenario is particularly suitable for maintenance processes, wherein a part is broken and requires replacement. In such cases, the maintenance process may comprise capturing the geometry of the broken physical object to obtain the mesh, or starting from an already available mesh, and executing the claimed method to generate a 3D model of the object including its specifications and a skeleton representation. The maintenance process may further comprise modifying S50 the 3D model by user interaction with at least one shared manipulable element of the skeleton representation generated by executing the method. This modification may comprise adapting the 3D model to enhance its robustness and prevent recurrence of breakage. The resulting output model comprises the reconstructed specification sequence and the associated skeleton, which complement each other and facilitate subsequent editing operations.

In a third scenario, the method may comprise enriching S124 existing specifications of a given model. In that case, the method comprises obtaining an initial model that already includes a partial or basic specification, which is the input in this case. The context relates to a situation where a beginner user wishes to revisit, enrich, or complement the design by applying best practices. The output is a model that includes its specification sequence, with the skeleton generated by the method complementing the specifications and facilitating their editing.

In a fourth scenario, the method comprises generating S125 the skeleton representation of an existing specification. The input comprises a model with specifications, meaning that the method obtains directly the specifications from the existing model (without computing it as in the previous scenarios). The context is that a user wishes to generate the skeleton to ease the editing of an existing model, which may be either a legacy design that lacks a skeleton representation or a model that was designed without a focus on editability. The goal is not to change the existing specifications but to describe them in a manner that favors editing. The output in this scenario is a model that includes its specification sequence, with the skeleton complementing the specifications and facilitating their editing. Thus, the step for obtaining the 3D model, referred to as step S10, comprises completing the sequence of typed operations of an initial model.

The method anticipates using the same component to generate the skeleton representation in scenario 1 (steps S121 and S122), scenario 2 (step S123), and scenario 3 (step S124). The differences between these scenarios reside in the nature of the input and the specification generation workflow, while the generation of the skeleton representation in scenario 4 (step S125) is specific because the features already exist and the skeleton is inserted into these existing features, which leads to a potentially larger list of configurations to be handled.

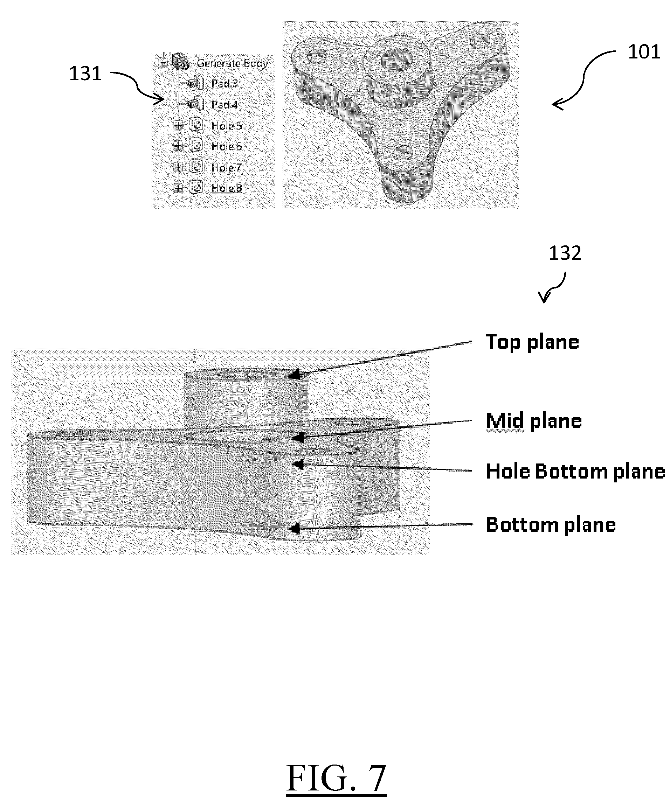

The skeleton generation step S20 is now discussed in more detail in reference to FIGs. 7 to 10.

The skeleton generation process facilitates describing a given 3D shape, composed of a specific list of features, in a manner that favors editing and enhances the model's robustness. For example, FIG. 7 illustrates a 3D model identical to the one discussed in reference to FIG. 5. The model comprises a sequence of typed operations 131 that includes generating two pads and four holes.

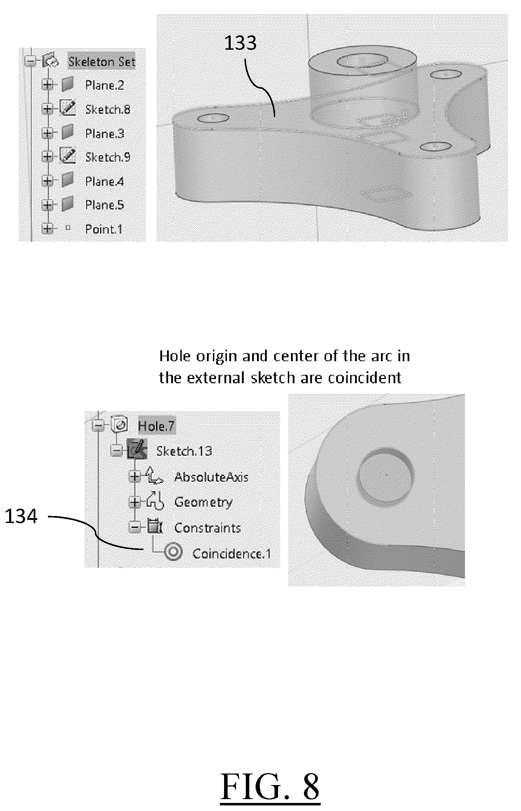

In a first step, the method identifies the driving elements (i.e., the parameters that are shared by at least two typed operations), which are gathered in what is called the skeleton set or skeleton representation. For example, the skeleton representation may comprise planes, sketches, axes and lines, and/or points. The driving elements are the wireframe elements that determine the shape of the model. They gather the remarkable elements that support the dimensions of the model and serve as handles that allow the designer to adapt the model and define variants. Each sketch used in a pad, a shaft, a pocket, or a groove may have a support plane, as shown by the support plane 133 illustrated in FIG. 8. These support planes 132 are created as offsets of a main plane (for example, the XoY, YoZ, or XoZ planes) wherever possible and without duplication. Instead of numerical values for length or depth in a feature, a plane corresponding to the end face may be created and set as a limit condition of type "UP TO". Concerning a hole, the origin is defined in a sketch and, when relevant, is constrained coaxially, while a line defines the hole's direction. As illustrated in the figure for this example, the hole origin and the center of the arc in the sketch are coincident (constraint 134).

Then, the method includes referencing these skeleton elements in the features definition, that is, in the parameters of the typed operations. Establishing these relationships determines how the features interact with each other and enables the transition from a set of independent features to a comprehensive model with expected behaviors. In the automated process, a plane may serve as a support or limit for sketches, pads, shafts, pockets, and grooves. A sketch may serve as the profile for pads, shafts, pockets, and grooves. An axis or line may serve as an axis for shafts and grooves or as the direction for holes. A point may serve as the origin for holes.

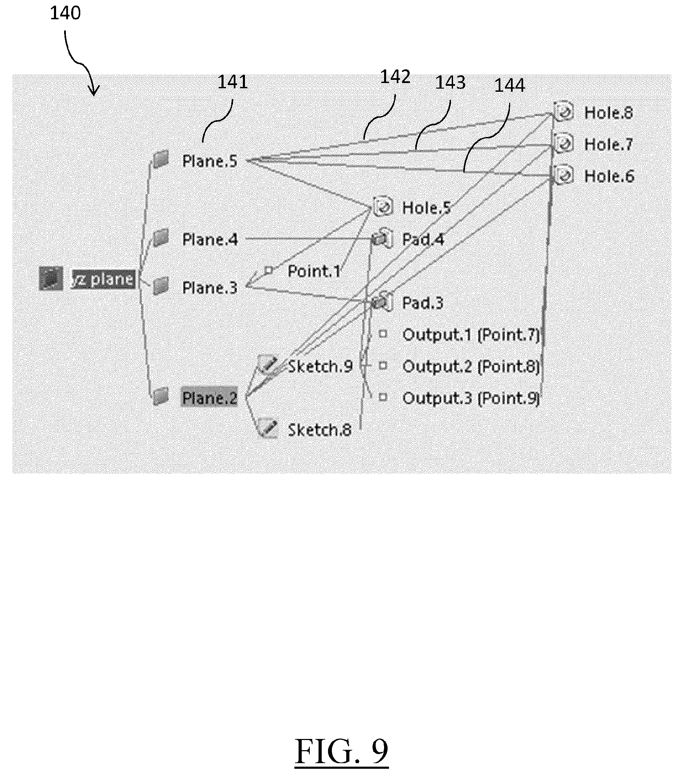

FIG. 9 illustrates the skeleton representation 140 generated by the method for the 3D model 101. The skeleton representation comprises several shared manipulable elements. Notably, it includes the shared manipulable element 141, which originates from the plane feature of the three holes that share the same plane. This element 141 is equivalent to that plane and includes references to each of the three holes 142, 143, and 144.

The resulting structure may then be easily edited manually by the user. The user may examine the skeleton representation, which gathers all the "actioners" or shared manipulable elements responsible for modifying the model. The designer may select the element or elements corresponding to the desired modification and apply the parameter change. The generation of the skeleton representation corresponds to capturing the design intent.

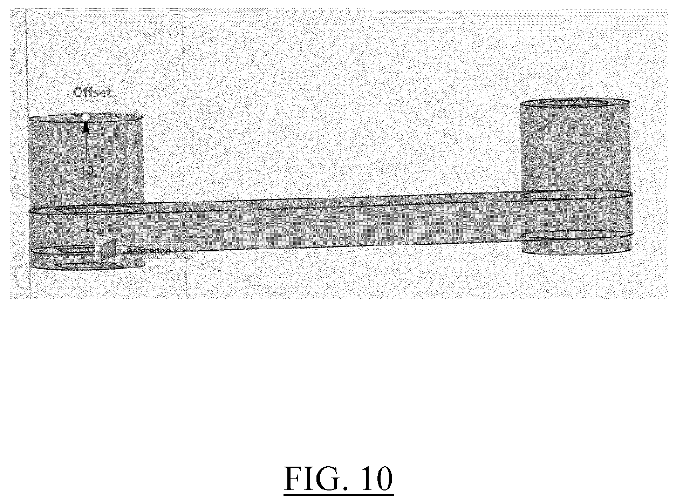

Although the process is challenging and the method may provide the best guess, it addresses the fact that the geometry does not inherently indicate whether, for example, two pads sharing the same top plane is coincidental or intended, as in the example illustrated in FIG. 10. By default, in such configurations, the method may consider the shared plane as intended and includes only one plane in the skeleton set.

For example, the method may propose flavors (i.e., variations) or alternative assumptions in the skeleton generation process to determine which assumption is accepted and to define the extent of the interpretation of design intent. This approach may for example be used in the scenario where the features sequence and the skeleton set are generated from a model without history (datum solid).

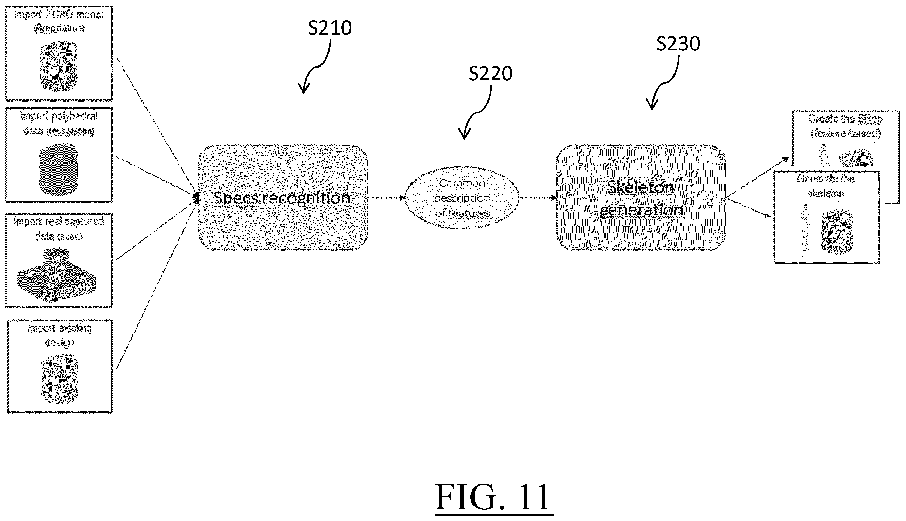

Further details on the skeleton generation step S20 are now provided in reference to FIGs. 11 to 16.

The skeleton generation step may be performed by following the pipeline process illustrated in FIG. 11. The first component S210 supports various model types as input, while the handover to the second component comprising (e.g., consisting of) skeleton identification S220 and skeleton creation S230 is based on a common neutral format. This common format comprises (e.g., consists of) a geometrical description of each identified feature so that the second component is not tied to any particular input type. The skeleton is generated from an abstract representation of the feature sequence that is an ordered list of operations. For example, supported operations include extrusion used for creating pads and pockets, revolution used for creating shafts and grooves, hole, fillet, and chamfer. Each operation is characterized by a set of attributes such as type, options, and a mathematical description of its geometric inputs. Examples of specification description for several typed operations are provided in the following tables:

**Table 1**

| Attribute Name | Description | Example of Value |
|---|---|---|
| Type | Type of the operation | Extrusion |
| RemoveMaterial | Remove or not material (i.e., create a Pad or a Pocket in case of extrusion) | false |
| Profile | Mathematical description of the 2D profile to be extruded | [ { startPt: [0,0], endPt: [10,0], |
| | | type: "line" }, ...] |
| Direction | Extrude direction | [0,0,1] |
| Length1 | Extrusion length, starting from profile, along extrude direction | 20 |
| Length2 | Extrusion length, starting from profile, along extrude direction at opposite side | 0 |

**Table 2**

| Attribute Name | Description | Example of Value |
|---|---|---|
| Type | Type of the operation | Revolution |
| RemoveMaterial | Remove or not material (i.e., create a Shaft or a Groove in case of revolution) | false |
| Profile | Mathematical description of the 2D profile to be extruded | [ { startPt: [0,0], endPt: [10,0], |
| | | type: "line" }, ...] |
| Revolution axis | Point + direction | [0,0,0] [0,0,1] |
| Start-Angle | Start of Revolution angle, starting from profile plane, | 0 |
| | perpendicular to revolution axis | |
| End-Angle | End of Revolution angle, starting from profile plane, perpendicular to revolution axis | 360 |

**Table 3**

| Attribute Name | Description | Example of Value |
|---|---|---|
| Type | Type of the operation | Hole |
| Predefined type | Simple, tapered, counterbored, countersunk, counterdrilled | Counterbored |
| Direction | Hole direction | [0,0,-1] |
| Origin | Reference point as point on plane perpendicular to above direction | [0,0] + Plane |
| Main Diameter | Main diameter of the hole | 10 |
| Main Depth | Depth defining the limit of the hole | 35 |
| Bottom type | Predefined type of hole bottom | flat |
| Tapered angle | Angle for tapered hole | 10 |
| Counterbored Diameter & depth | Larger diameter and depth for counterbored hole | 30, 5 |
| Countersunk angle & depth | Angle and depth for countersunk hole | 30, 5 |
| Counterdrilled diameter, depth & angle | Larger diameter, depth and angle for counterdrilled hole | 30, 5, 45 |

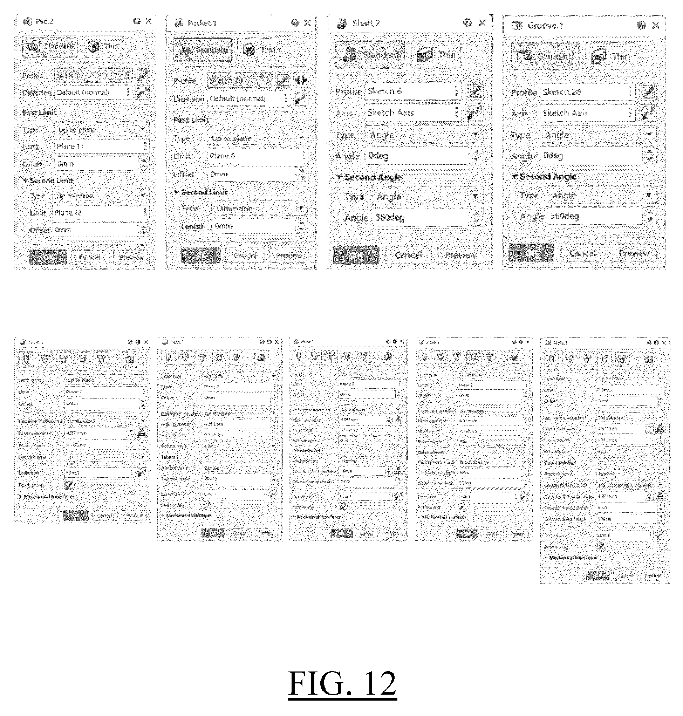

FIG. 12 illustrates an example of a graphical interface that may be used by the user for setting parameters of typed operations. The list of typed operations may be computed by the method from various inputs such as a Brep, a tessellation model, a scan, and others (as previously discussed).

The skeleton is generated during the production of the feature tree.

An overview of the algorithm is as follows. For each operation described in the operation list, the method extracts the mathematical definition of the elements (i.e., the parameters) that are candidates for inclusion in the skeleton. The extraction may use (e.g., depends on) the type of operation. Each extracted element is then compared to the mathematical definitions of the skeleton features already generated (i.e., the parameters that have already been added to the skeleton representation). If a match is found, the existing skeleton feature is reused. If no match is found, a new feature is created and added to the skeleton. The creation of the new skeleton feature is carried out in a manner that attempts to preserve associativity with reference elements from the part.

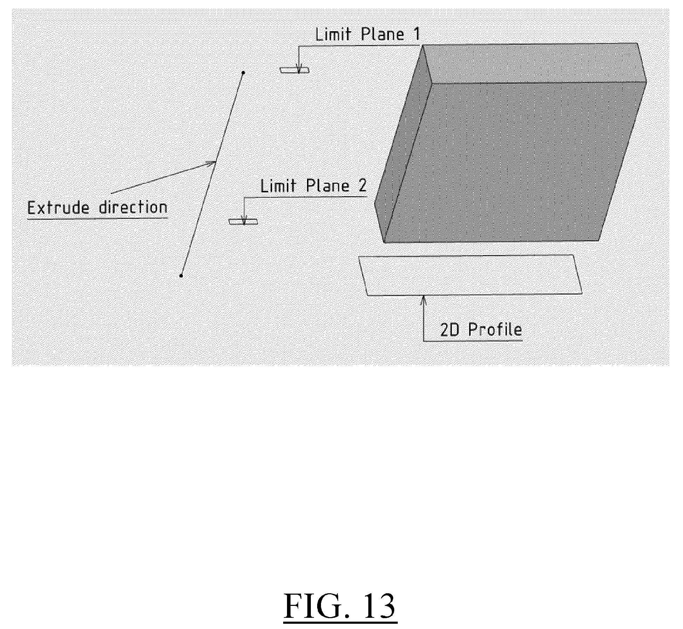

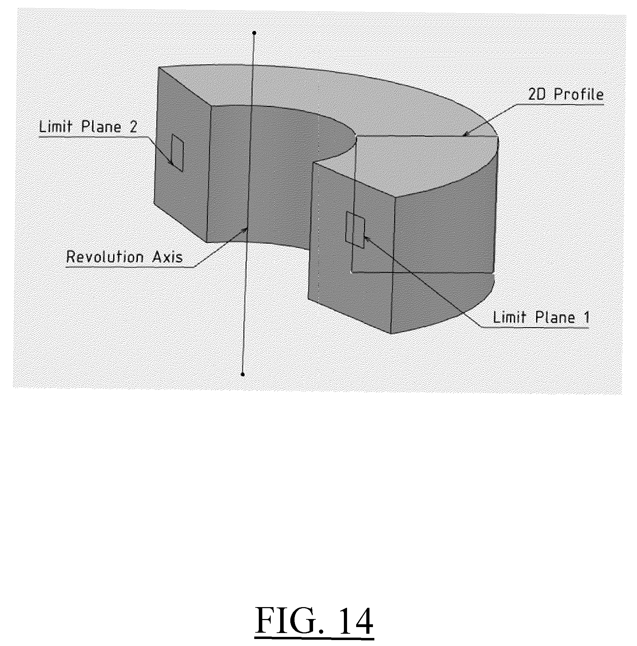

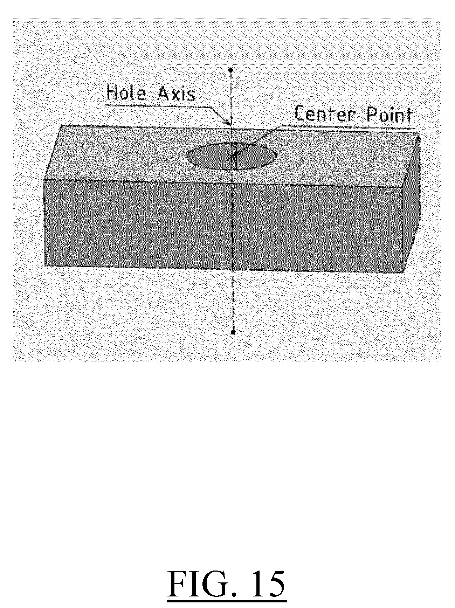

The extraction of elements for exposure in the skeleton may use (e.g., depends on) the type of operation. In the case of an extrusion operation as illustrated in FIG. 13, the method may extract the support plane of the two-dimensional profile and the limit planes corresponding to length limits. For a revolution operation as illustrated in FIG. 14, the method may extract the support plane of the two-dimensional profile, the revolution axis, and the planes corresponding to angle limits for a partial revolution. For a hole operation as illustrated in FIG. 15, the method may extract the hole center point, the hole axis, and the hole limit expressed as the plane corresponding to the depth. Based on the algorithm described above, each extracted element is converted into an associative feature in the skeleton. It should be noted that fillet and chamfer operations may be regarded as dress up operations. It means that, although they are included in the operations sequence, no skeleton element may be associated with either of them.

Associative skeleton features may be computed according to the following specific rules. A global axis system may be considered, which may be based on the reference planes of the part or on a dedicated axis system defined by the user. All created skeleton features and their parametric definitions, for example the extrude direction, may be expressed relative to this global axis system. For plane features such as the support plane of a two dimensional profile or the limit planes for extrusion and revolution operations, if the plane is parallel to one of the global axis system planes then an offset plane feature may be created associatively with the detected reference plane using the appropriate offset value. Otherwise, the plane may be created as an isolated datum plane. In the case of the revolution axis, if it is part of the two dimensional profile's plane then the axis may be created as a two dimensional axis within the sketch feature. Otherwise, the axis may be created as a line feature defined by a point and a direction. Hole center points may be created as point on plane features, with the plane created using the hole axis as the normal direction. Similarly, the hole axis may be created as a line feature defined by a point and a direction.

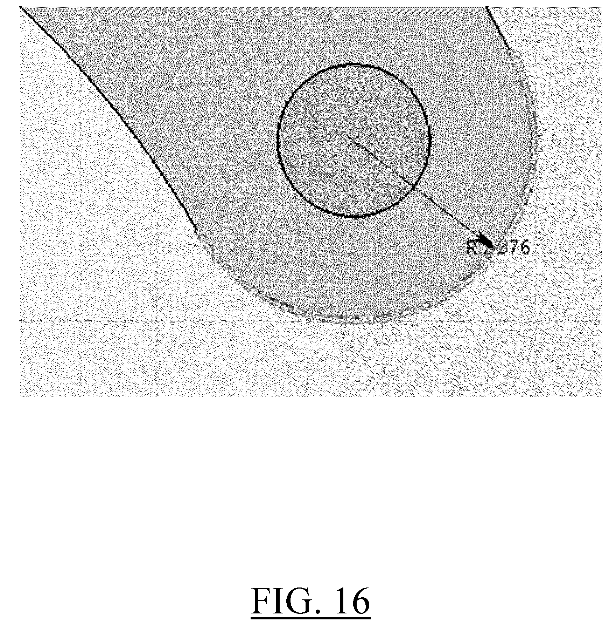

In order to establish the hole origin as a constraint in other feature profiles where necessary (see example of FIG. 16), the method may perform two iterations. The first iteration may focus on the creation of skeleton features associated with holes, and the second iteration may process the remaining features. The execution of this algorithm results in an associative network of skeleton elements that supports the procedural design.

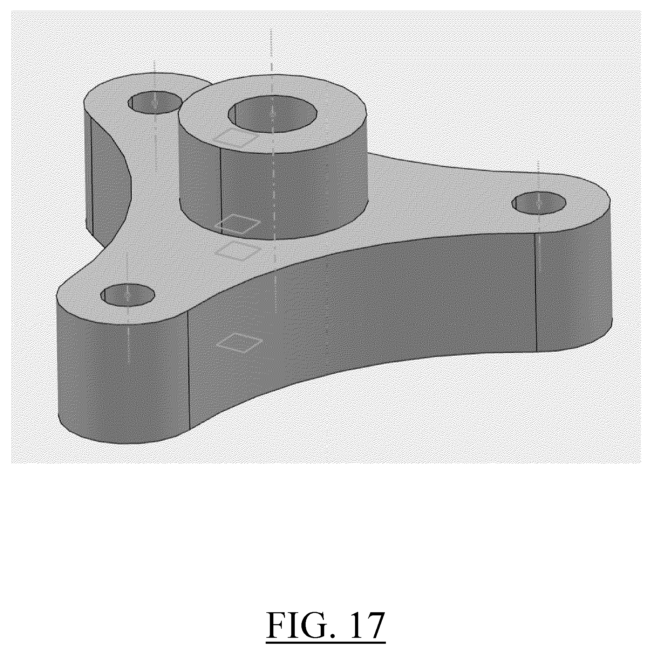

A detailed example is now presented with reference to FIGs. 17 to 23. The model considered is illustrated in FIG. 17.

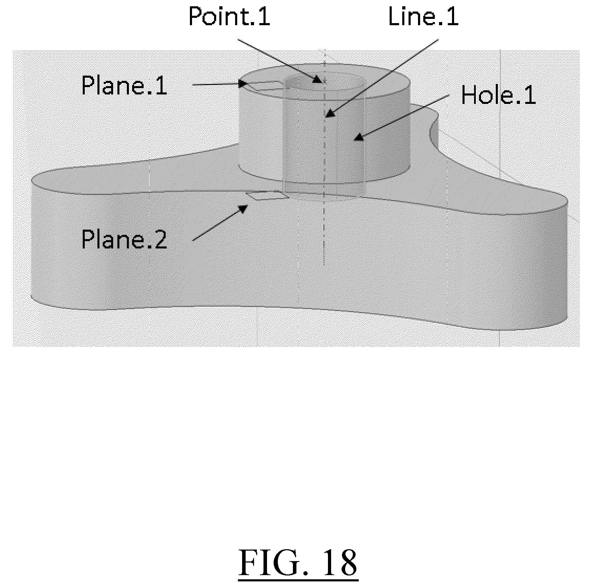

In a first iteration, the method creates the skeleton associated with the holes (the references are indicated in FIG. 18). The first hole, designated as Hole 1, has its origin created as Point 1. Since Point 1 does not already exist in the skeleton, it is created and added. Its direction is created as Line 1 and, because Line 1 is not already present, it is added to the skeleton. Its origin plane is created as Plane 1 as an offset of the reference plane and added to the skeleton, and its limit is created as Plane 2, also as an offset of the reference plane.

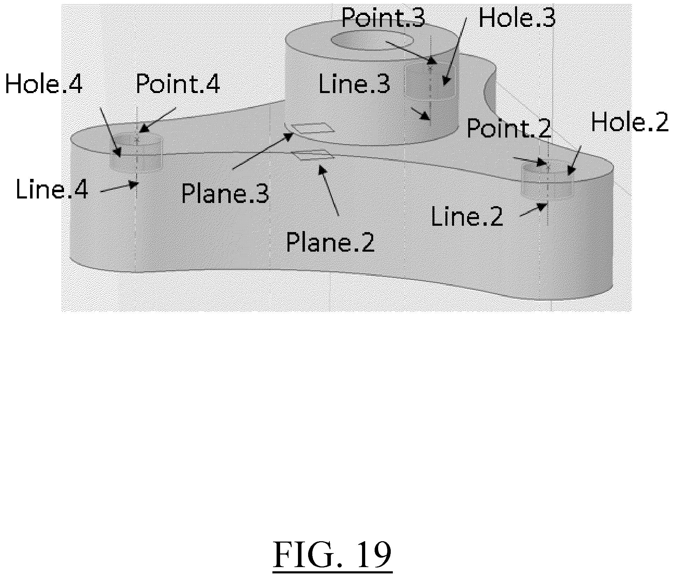

Following this, the holes designated as Hole 2, Hole 3, and Hole 4 are processed (the references are indicated in FIG. 19). Their origins are created as Point 2, Point 3, and Point 4 respectively and, since these points do not already exist, each is added to the skeleton. Their directions are created as Line 2, Line 3, and Line 4 respectively and added as new line features. Their origin plane is created as Plane 3 and added to the skeleton if it does not already exist; Plane 3 is then reused for Hole 3 and Hole 4. Their limit is expressed as Plane 2 which already exists and is therefore reused for Hole 2, Hole 3, and Hole 4.

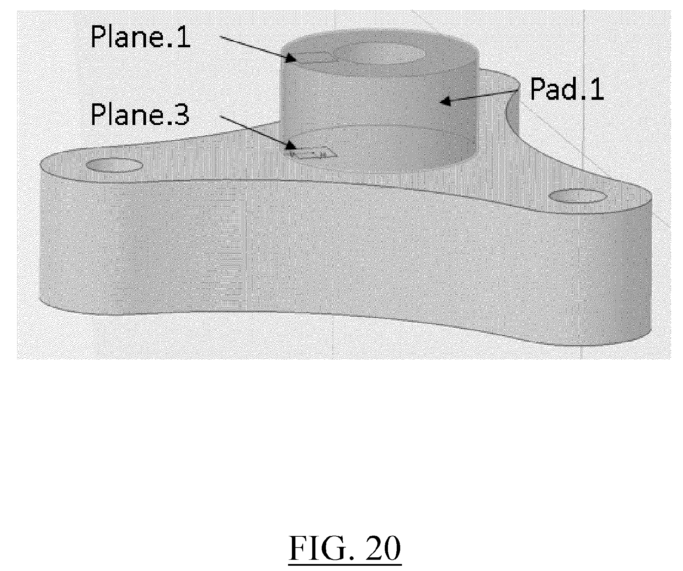

In a second iteration, the method processes other features such as pads and pockets. For example, the pad designated as Pad 1, illustrated in FIG. 20, has a profile that lies on Plane 3, which already exists and is reused for Pad 1. Its limit is expressed as Plane 1, which is also reused.

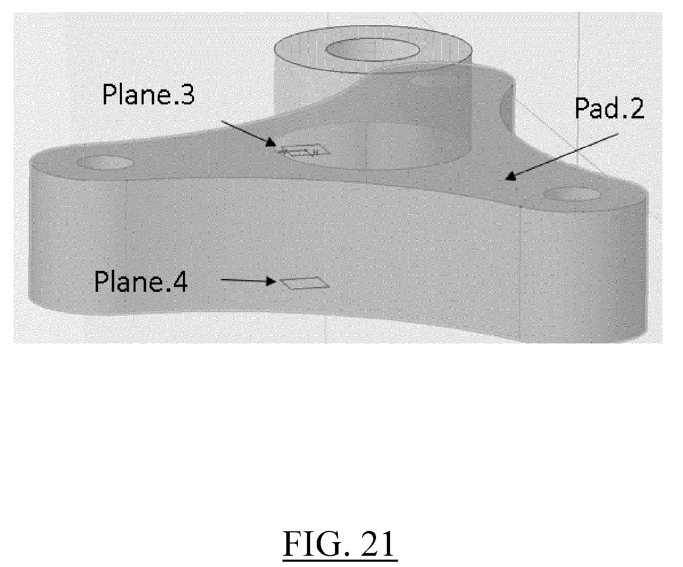

The next feature, Pad 2 as shown in FIG. 21, has a profile that again lies on Plane 3, while its limit is expressed as Plane 4. Because Plane 4 does not yet exist, it is created and added to the skeleton.

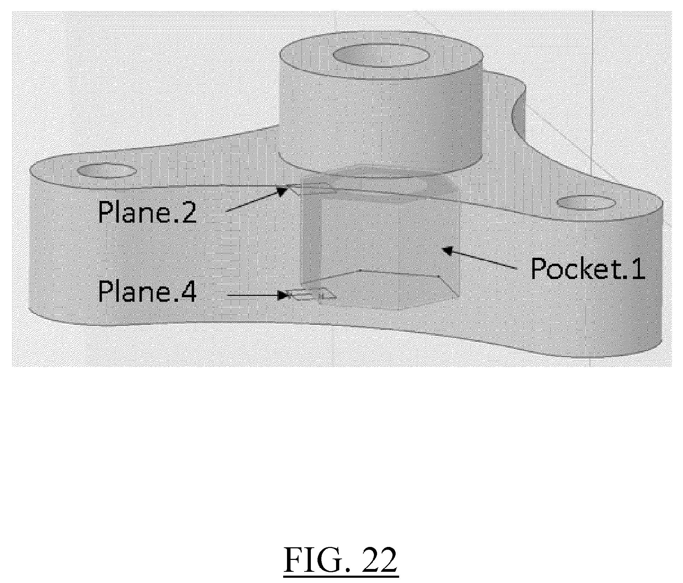

Finally, for Pocket 1 illustrated in FIG. 22, the profile lies on Plane 4, which already exists, and its limit is expressed as Plane 2 and therefore reused.

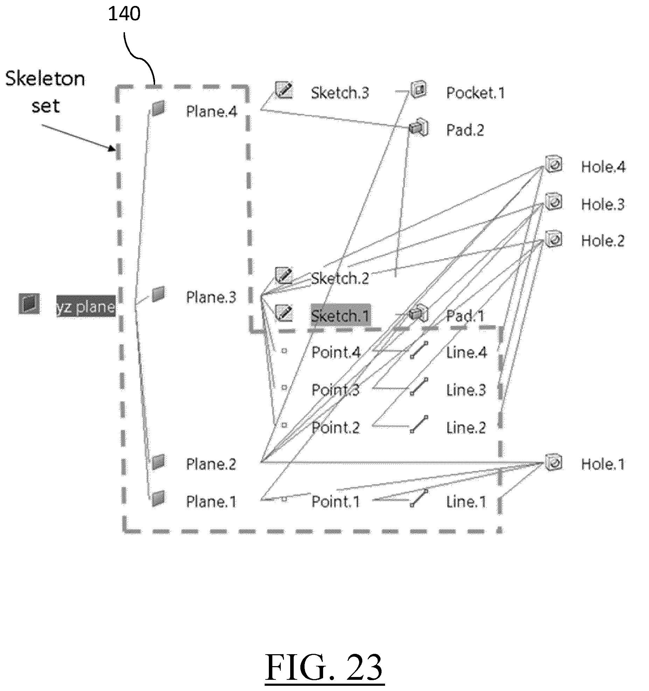

The processing results in the establishment of relationships between the shared manipulable elements and the parameters of the typed operations, as illustrated in FIG. 23, which shows the resulting skeleton representation 140.

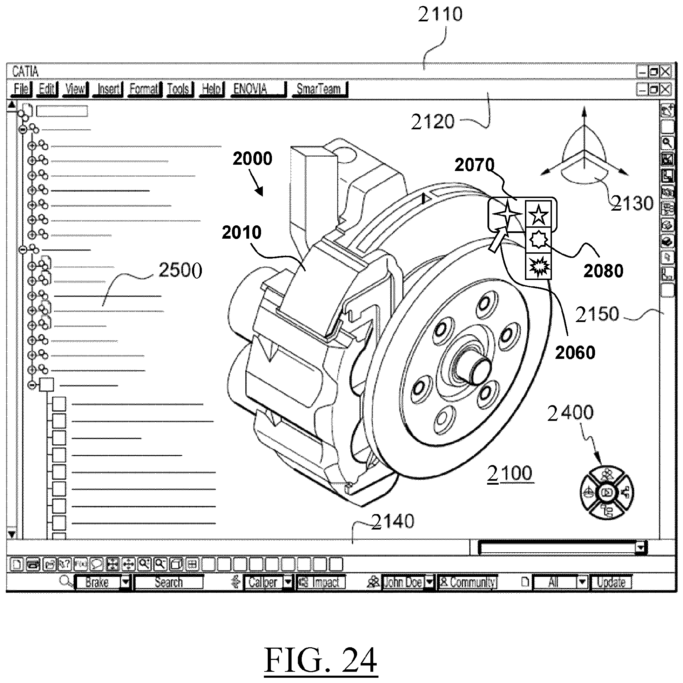

FIG. 24 shows an example of the GUI of the system, wherein the system is a CAD system.

The GUI 2100 may be a typical CAD-like interface, having standard menu bars 2110, 2120, as well as bottom and side toolbars 2140, 2150. Such menu- and toolbars contain a set of user-selectable icons, each icon being associated with one or more operations or functions, as known in the art. Some of these icons are associated with software tools, adapted for editing and/or working on the 3D modeled object 2000 displayed in the GUI 2100. The software tools may be grouped into workbenches. Each workbench comprises a subset of software tools. In particular, one of the workbenches is an edition workbench, suitable for editing geometrical features of the modeled product 2000. In operation, a designer may for example pre-select a part of the object 2000 and then initiate an operation (e.g. change the dimension, color, etc.) or edit geometrical constraints by selecting an appropriate icon. For example, typical CAD operations are the modeling of the punching or the folding of the 3D modeled object displayed on the screen. The GUI may for example display data 2500 related to the displayed product 2000. In the example of the figure, the data 2500, displayed as a "feature tree", and their 3D representation 2000 pertain to a brake assembly including brake caliper and disc. The GUI may further show various types of graphic tools 2130, 2070, 2080 for example for facilitating 3D orientation of the object, for triggering a simulation of an operation of an edited product or render various attributes of the displayed product 2000. A cursor 2060 may be controlled by a haptic device to allow the user to interact with the graphic tools.

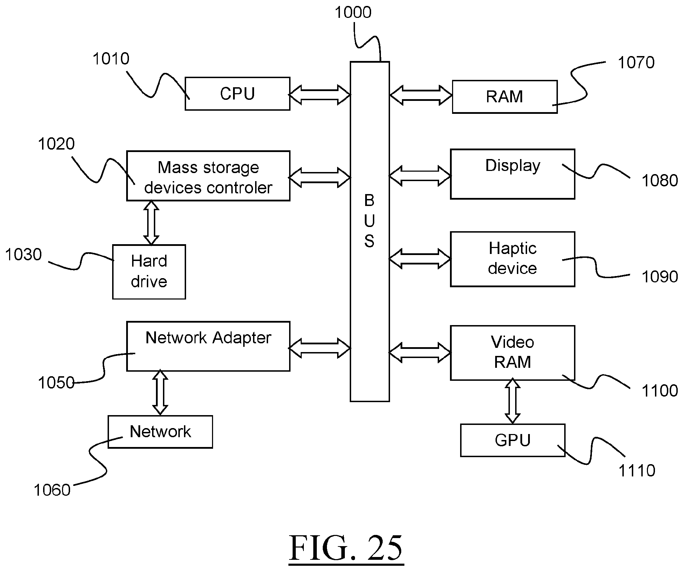

FIG. 25 shows an example of the system, wherein the system is a client computer system, e.g. a workstation of a user.

The client computer of the example comprises a central processing unit (CPU) 1010 connected to an internal communication BUS 1000, a random access memory (RAM) 1070 also connected to the BUS. The client computer is further provided with a graphical processing unit (GPU) 1110 which is associated with a video random access memory 1100 connected to the BUS. Video RAM 1100 is also known in the art as frame buffer. A mass storage device controller 1020 manages accesses to a mass memory device, such as hard drive 1030. Mass memory devices suitable for tangibly embodying computer program instructions and data include all forms of nonvolatile memory, including by way of example semiconductor memory devices, such as EPROM, EEPROM, and flash memory devices; magnetic disks such as internal hard disks and removable disks; magneto-optical disks. Any of the foregoing may be supplemented by, or incorporated in, specially designed ASICs (application-specific integrated circuits). A network adapter 1050 manages accesses to a network 1060. The client computer may also include a haptic device 1090 such as cursor control device, a keyboard or the like. A cursor control device is used in the client computer to permit the user to selectively position a cursor at any desired location on display 1080. In addition, the cursor control device allows the user to select various commands, and input control signals. The cursor control device includes a number of signal generation devices for input control signals to system. Typically, a cursor control device may be a mouse, the button of the mouse being used to generate the signals. Alternatively or additionally, the client computer system may comprise a sensitive pad, and/or a sensitive screen.

The computer program may comprise instructions executable by a computer, the instructions comprising means for causing the above system to perform the method. The program may be recordable on any data storage medium, including the memory of the system. The program may for example be implemented in digital electronic circuitry, or in computer hardware, firmware, software, or in combinations of them. The program may be implemented as an apparatus, for example a product tangibly embodied in a machine-readable storage device for execution by a programmable processor. Method steps may be performed by a programmable processor executing a program of instructions to perform functions of the method by operating on input data and generating output. The processor may thus be programmable and coupled to receive data and instructions from, and to transmit data and instructions to, a data storage system, at least one input device, and at least one output device. The application program may be implemented in a high-level procedural or object-oriented programming language, or in assembly or machine language if desired. In any case, the language may be a compiled or interpreted language. The program may be a full installation program or an update program. Application of the program on the system results in any case in instructions for performing the method. The computer program may alternatively be stored and executed on a server of a cloud computing environment, the server being in communication across a network with one or more clients. In such a case a processing unit executes the instructions comprised by the program, thereby causing the method to be performed on the cloud computing environment.

## Claims

1. A computer implemented method for designing a 3D model of an object, the method comprising:
• obtaining (S10) the 3D model of the object, the 3D model being represented by a sequence of one or more typed operations, each typed operation being defined by a set of respective parameters; and
• generating (S20) a skeleton representation of the 3D model comprising one or more shared manipulable elements, each referenced by at least two respective typed operations, a reference between a given shared manipulable element and a given typed operation defining a displacement relationship between the shared manipulable element and a parameter defining the given typed operation.

2. The method of claim 1, wherein the generating (S20) of the skeleton representation comprises determining (S21) the one or more shared manipulable elements of the skeleton representation by:
• extracting (S30) candidate parameters of the one or more typed operations representing the 3D model; and
• sequentially processing (S40) the extracted candidate parameters to add to the skeleton representation a shared manipulable element for each set of at least two similar extracted candidate parameters.

3. The method of claim 2, wherein the sequentially processing (S40) comprises, for each extracted candidate parameter:
• determining (S41) whether the candidate parameter corresponds to an already added shared manipulable element in the skeleton representation; and
• if no corresponding shared manipulable element exists, adding (S42) the candidate parameter as a new shared manipulable element in the skeleton representation; or
• if a corresponding shared manipulable element exists, establishing (S43) a reference between the typed operation associated with the candidate parameter and the existing shared manipulable element.

4. The method of claim 3, wherein the determining (S41) of whether the candidate parameter corresponds to an already added shared manipulable element in the skeleton representation is performed by comparing a geometry of the candidate parameter and a geometry of each shared manipulable element already present in the skeleton.

5. The method of claim 4, wherein the comparison is performed by considering a predetermined tolerance.

6. The method of any one of claims 2 to 5, wherein the extracted candidate parameters comprise all parameters of the one or more typed operations that belong to a predetermined set of categories.

7. The method of claim 6, wherein the predetermined set of categories includes:
• a plan category,
• a point category, and
• an axis category.

8. The method of any one of claims 1 to 7, wherein the obtaining (S10) of the 3D model comprises determining the one or more typed operations of the 3D model by reconstructing an initial model.

9. The method of claim 8, wherein the initial model is:
• a mesh of the object,
• a tessellation of the object, or
• a Brep.

10. The method of any one of claims 1 to 7, wherein the obtaining (S10) of the 3D model comprises determining the one or more typed operations of the 3D model from an existing model designed by a user.

11. The method of any one of claims 1 to 10, wherein the one or more typed operations include:
• at least one extrusion operation,
• at least one revolution operation, and/or
• at least one hole operation.

12. The method of any one of claims 1 to 11, further comprising modifying (S50) the 3D model through user interaction with at least one shared manipulable element of the skeleton representation.

13. A computer program comprising instructions which, when executed by a computer, cause the computer to carry out the method of any of claims 1 to 12.

14. A computer readable storage medium having recorded thereon the computer program of claim 13.

15. A system comprising a processor coupled to a memory, the memory having recorded thereon the computer program of claim 13.
